Europäisches Patentamt

European Patent Office

Office européen des brevets

(19)

(11) Publication number: **0 153 303**
**B1**

(12) **EUROPEAN PATENT SPECIFICATION**

(45) Date of publication of patent specification: **12.04.89**

(51) Int. Cl.⁴: **G 01 N 24/08**

(21) Application number: **83902568.1**

(22) Date of filing: **05.08.83**

(86) International application number:
**PCT/EP83/00208**

(87) International publication number:
**WO 85/00887 28.02.85 Gazette 85/05**

(54) **METHOD AND APPARATUS FOR OBTAINING N.M.R. SPECTRA.**

(43) Date of publication of application:
**04.09.85 Bulletin 85/36**

(45) Publication of the grant of the patent:
**12.04.89 Bulletin 89/15**

(84) Designated Contracting States:
**CH DE FR LI NL SE**

(56) References cited:
**WO-A-81/02788**
**GB-A-2 026 172**
**GB-A-2 105 853**
**GB-A-2 113 399**
**US-A-4 021 726**

(73) Proprietor: **Oxford Research Systems Limited**
**Nuffield Way**
**Abingdon Oxon OX14 1RY (GB)**

(72) Inventor: **GORDON, Robert, Emslie**
**35 Rivermead Road**
**Rose Hill Oxford (GB)**
Inventor: **ORDIDGE, Rodger, John**
**6 Fruitlands**
**Eynsham Oxon (GB)**

(74) Representative: **Patentanwälte Kohler -**
**Schwindling - Späth**
**Hohentwielstrasse 41**
**D-7000 Stuttgart 1 (DE)**

Courier Press, Leamington Spa, England.

## Description

The invention relates to a method of obtaining N.M.R. spectra from a specific volume within a sample volume according to the preamble of claim 1.

This method, which is described in US—A— 4 021 726, allows obtaining information of two- and three-dimensional images of the spin density distribution in materials containing nuclear spins. This method is specified by "tailored saturation". It makes use of preparatory radiation rf pulses having an envelope, the width thereof being relatively long, of the order of the spin-lattice relaxation time $T_1$, so that the irradiated spins have their magnetization destroyed. Tailoring by this method is achieved by frequency and/or amplitude modulation of the pulse envelope.

It is an object of the present invention to enhance the information, obtainable by the known method in that high resolution N.M.R. spectra may be obtained from specific volumes of minimum dimensions within a sample rather than obtaining only information about spin density profiles.

According to the invention, this goal is achieved by the measure defined by the characterizing part of claim 1.

The main advantage of this new method is thus that high resolution N.M.R. spectra may be obtained from specific points within a sample, e.g. a living human body. It is, therefore, possible to take advantage of any of the known preparatory N.M.R. methods to obtain additional information pointwise within the living sample. For example, information may be obtained about the chemical configuration of the specific measuring point or physical properties may be determined, for example the value of pH or the specific temperature which are known to influence the chemical shift within an N.M.R. spectrum.

The invention relates further to an apparatus for obtaining an N.M.R. spectrum from a specific volume within a sample volume according to the preamble of claim 13.

It is another object of the invention to provide an apparatus with enhanced possibilities to investigate the physical characteristics of a microscopic volume within a sample volume, using N.M.R. spectroscopy.

This goal is achieved by using within the above-mentioned apparatus, means as specified in the characterizing part of claim 13.

Further embodiments of the invention are described in the dependent claims.

The invention will be more readily understood by explanation with reference to the accompanying drawings, in which:

Fig. 1 illustrates in diagrammatic form a sample to be analyzed,

Fig. 2 illustrates in schematic form waveforms to be applied in carrying out a method according to the invention;

Fig. 3 illustrates in schematic form various alternative waveforms; and

Fig. 4 is an illustration of desired frequency envelopes for various rf pulses.

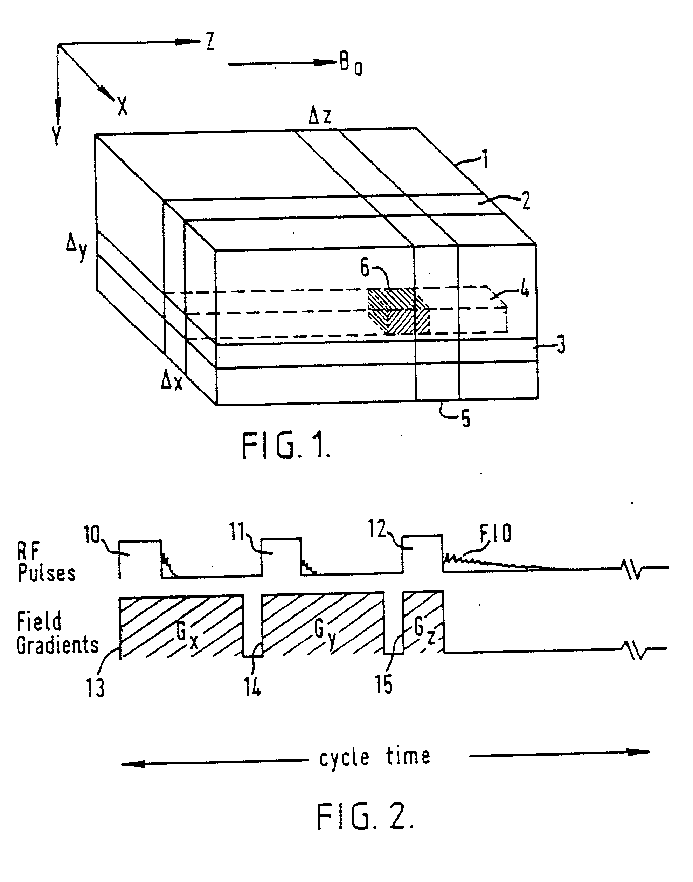

Referring to Fig. 1, a small volume in a sample is represented as a cube 1, positioned with its sides parallel to three orthogonal axes X, Y and Z. Cube 1 is placed in a static homogeneous magnetic field $B_o$, as illustrated in Fig. 1.

In the simplest case, the third direction along which the field gradient is applied is the Z direction (i.e. the direction of $B_o$), and the said first and second directions may, for example, be vertical and horizontal directions in the laboratory frame. There is, however, no necessity that the three directions X, Y and Z should be coincident with any particular direction of the magnet, and, for example, mutually orthogonal gradients may be produced by the use of combinations of gradient coils as used in a conventional N.M.R. spectrometer. For simplicity, however, the invention will be illustrated for the case when the Z direction is coincident with the direction of $B_o$.

A field gradient $G_x$ is applied along the X direction of a sufficient magnitude to provide a measurable difference in rf resonance frequency for nuclei of a particular type in the volume 1. Typical values for the magnitude of the field gradient would be of the order of $5.10^{-5}$ T/cm (0.5 gauss/cm).

Whilst the magnetic field gradient $G_x$ is applied, an rf pulse is applied to the sample so as to effect the selective saturation of spins in the sample. The saturation is selective in that all the nuclei of a particular type (typically protons, although any nuclei having a suitable magnetic moment), such as $13_c$ or $31_p$ could be utilized) within the volume 1 are saturated by the pulse, with the exception of those within a slice $\Delta x$ in the Y, Z plane, i.e. orthogonal to the X axis.

Fig. 2 illustrates schematically the time scale over which the rf pulse 10 is applied, in comparison with the field gradient $G_x$.

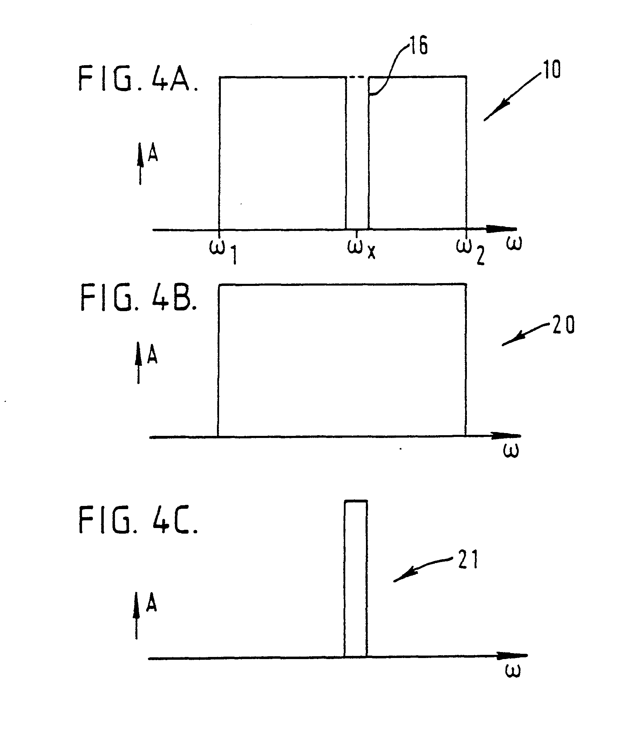

To produce the desired saturation of all spins *except* those within the slice 2 of thickness $\Delta x$, the radio-frequency pulse applied must have a frequency distribution somewhat of the type illustrated in Fig. 4(a), in which the horizontal axis now represents radio-frequency, and the vertical axis represents amplitude. It can be seen that, in effect, the waveform has a "notch", at a frequency corresponding to the resonant frequency of the slice 2. Such a waveform can be produced by calculating the desired frequency distribution, and applying Fourier transform techniques, to produce the appropriate amplitude modulation for the rf pulse. This technique of pulse shaping is commonly used in Nuclear Magnetic Resonance, and is referred to, for example, in papers by R. J. Sutherland and J. M. S. Hutchison (J. Phys. E. Sci, Instrum., Vol. 11, 1978), and by J. M. S. Hutchison, R. J. Sutherland, and J. R. Mallard (J. Phys. E. Sci. Instrum., Vol. 11, 1978).

The saturated nuclear spins in the portion of the volume *not* in the slice 2 are initially in phase, and the gradient $G_x$ is maintained for a period of time sufficient to permit the spins to dephase.

A second field gradient represented by block 14 in Fig. 2 is then applied to the magnetic field in the Y direction. Whilst the magnetic field is applied, an rf pulse 11 is applied to the sample, such as to saturate all the spins of the particular type of nuclei under investigation in the volume, with the exception of those in a slice 3 of thickness $\Delta y$, in the X, Z plane (i.e. normal to the Y direction). The waveform of the rf pulse 11 may similarly be calculated by Fourier transform techniques.

The net effect of the two pulses 10 and 11 is thus to leave unsaturated only the nuclear spins in a column 4, which is common to both slice 2 and slice 3. This column 4 extends in the Z direction.

A field gradient $G_z$ is now applied in the Z direction, as illustrated in Fig. 2, and an rf pulse 12 is applied to selectively interact with nuclei in a short length of the column 4. The pulse 12 does not interact with those nuclei lying outside column 4, since the spins of those nuclei are already saturated by pulses 10 and 11. Pulse 12 is selected to have a similar frequency distribution to that of pulses 10 and 11, so that it interacts only with those nuclei lying within a slice 5 orthogonal to the Z axis. Thus, only those nuclei lying in a small element 6 of column 4, where column 4 and slice 5 coincide, interact with pulse 12.

The field gradient Z is then removed, and the spins in element 6 are allowed to decay in the absence of any magnetic field gradients, that is to say in the homogeneous static magnetic field $B_o$ only.

The resulting free induction decay (FID) signal will thus represent almost entirely the transient response from the element 6, and not from any other part from the volume represented by the block 1. The free induction decay signal can be subjected to Fourier transformation in conventional manner, to yield spectral information about the element. The cycle represented by Fig. 2 is repeated a sufficient number of times to obtain information of the desired accuracy about element 6, and is then repeated with a pulse waveform 12 having a notched "shape" (represented by Fig. 4(a)) corresponding to a different position along the Z axis for the slice 5. Thus, the length of the column 4 is "scanned", and data obtained for each of the series of element 6 along column 4. In a similar way, the X and Y directions can be scanned, to build up a three-dimensional spectrum for the whole of the volume represented by the block 1.

Although the cycle illustrated in Fig. 2 is relatively simple from a conceptual point of view, the tailoring of pulse waveform to produce a frequency distribution as shown in Fig. 4(a) is in practice quite difficult to achieve. This is because the amplitude envelope produced by Fourier transformation of the frequency distribution of Fig. 4(a) consists of a fairly sharp pulse of large amplitude, with a number of side pulses of much lower amplitude. Thus, in order to reproduce the waveform accurately, a radio-frequency transmitter with a very large dynamic range is required.

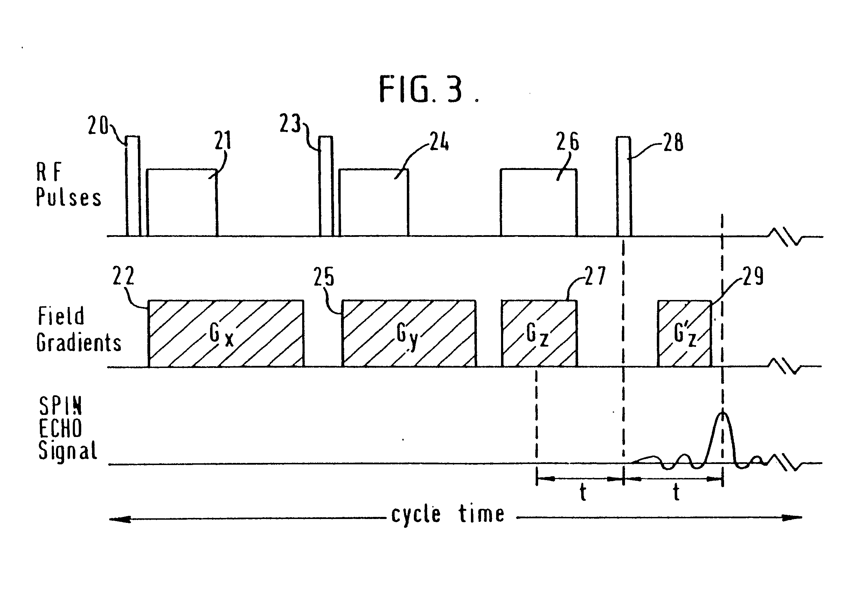

Therefore, in a preferred method according to the invention, the selective saturation is achieved using two rf pulses. A first rf pulse saturates substantially all of the spins of the appropriate type in the block 1. This pulse can be of relatively short duration (for example from 1 to 500 microseconds, typically 50 microseconds), and high amplitude. The saturation is made selective by a restoring pulse, which is adapted to reverse in the region of the respective slice 2 or 3 the effect of the saturating pulse. This is illustrated schematically in Fig. 3, and the frequency distribution envelopes of the pulses 20 and 21 in Fig. 3 are illustrated schematically in Figs. 4(b) and 4(c).

By the use of two separate pulses, it is possible either to use two separate radio-frequency transmitters, one adapted for high amplitude and one for low amplitude modulation, or alternatively a single radio-frequency transmitter able to operate in a high amplitude mode, or a low amplitude mode. Thus, significantly better control over the frequency envelope can be obtained. The saturating pulses 20 and 23 will typically have a duration of approximately 50 microseconds, and may be applied either before the application of the respective gradients 22 and 25, or in the presence of these gradients. The presence of gradients during the saturation pulses 20 and 23 will, however, have the effect of broadening the frequency spectrum over which excitation is required, and thus it is preferred that the saturating pulses 20 and 23 are applied in the absence of field gradients.

Restoring pulses 21 and 24 may be thought of as representing a frequency distribution somewhat as shown in Fig. 4(c) and, will be 180° out of phase with the saturating pulses 20 and 23. Restoring pulses 20 and 21 will typically have a duration of from 1 to 5 milliseconds, for example 2 milliseconds.

After application of the pulses 21 and 24, gradients $G_x$ and $G_y$ are maintained for a period of time sufficient to allow dephasing of the saturated spins in the volume block 1. The length of time required will be of the same order as the duration of the pulses 21 and 24, for example 2 milliseconds.

Fig. 3 also illustrates a further preferred technique in accordance with the method of the invention, that of "refocusing" the signal evolution to produce a spin-echo. The refocusing technique is well-known in Nuclear Magnetic Resonance, and is described, for example, in the Sutherland and Hutchison papers mentioned above.

Refocusing can be achieved by applying to the sampe after the pulse 26 which is applied in the presence of a gradient 27 in the Z direction, a further pulse 28, such as to cause 180° nutation of the nuclear spins under investigation. In addition, a gradient 29 in the Z direction is applied following the refocusing rf pulse 28. Not only does this method have the effect of producing a spin-echo, but also it has the advantage of removing signal evolution due to magnetic field inhomogeneity, and rephasing the signal evolution from nuclei with different chemical shifts. The free induction decay following will, therefore, appear to commence from a zero time origin as illustrated in the lower part of Fig. 3.

The techniques of refocusing are adequately described elsewhere, and such references should be considered to be incorporated herein by reference. It should be noted that the pulse 26 should be tailored so as to enable refocusing of the signal evolution to produce spin-echo.

An alternative method of refocusing signal evolution is to reverse the direction of the magnetic field gradient $G_z$, after a predetermined period of time.

To produce the desired waveforms, a digital-to-analogue converter may be provided to produce the radio-frequency waveforms, and because of the complexity of the radio-frequency pulses required, it should be noted that a particularly large memory requirement is imposed in respect of the electronics responsible for driving the radio-frequency transmitter.

The strengths or slopes of the gradients to magnetic field $B_o$ should be strong in comparison with any residual gradients from inhomogeneities in field $B_o$. Some of the criteria for determining the strength of the gradients are discussed below.

In a high resolution N.M.R. experiment each nucleus resonates at a field of magnitude B' given by

$$B'=(1-\delta)B \qquad (1)$$

Where $\delta$ is the chemical shift. If this experiment is repeated in the presence of a linear field gradient $G_x$ then for one dimension equation (1) has to be modified as follows:

$$B'_i=(1-\delta_i)B \pm G_x x_i \qquad (2)$$

where for the $i^{th}$ nucleus $B'_i$, $\delta_i$ and $x_i$ are the resonant field, chemical shift and spatial location, respectively. Equation (2) can be rearranged to give:

$$B'_i/B=1-\delta_i \pm G_x x_1/B \qquad (3)$$

The term $G_x x_i/B$ can be considered as a pseudo chemical shift term. The presence of the gradient $G_x$, therefore, extends the chemical shift range. Consequently, the spectral band width of the transmitter must be increased accordingly if all the spins are to be excited. If, however, a narrow part of the chemical shift range is excited by selective irradiation then only nuclei in a slice of thickness $\Delta x$ and mean location $x_m$ will resonate. In other words, the effect of applying the gradient $G_x$ has been to spatially label the spins. In general, the sample will produce a multi-line spectrum with each line resonating at a particular chemical shift $\delta_i$ within a range $\pm\delta_o$, where $2\delta_o$ is the expected total width of the spectrum. In a homogeneous static magnetic field the spectra that would be obtained from successive slices $\Delta x$ would be identical but in the presence of a linear gradient $G_x$ the resonant frequency now depends not only on $\delta_i$ but also on $x_i$ so that the relative positions of the spectral lines within each slice $\Delta x$ will be distorted. Furthermore, the relative proportions of these lines may also be altered by lines being frqeuency shifted outside the selective irradiation bandwidth and by lines from adjacent slices being shifted to be inside the irradiation bandwidth.

Additionally in the presence of a field gradient the individual line shapes will inevitably be broadened so that overlap from adjacent slices can be caused not only by frequency shifts but also by line broadening. Both of these effects can be minimized by choosing $G_x$ such that the irradiation frequency depends only on the pseudo chemical shift term. If the slice has a width d then $G_x$ must satisfy the condition that

$$G_x \geq 2\delta_o B/d \ . \qquad (4)$$

The above condition for the magnitude or gradient $G_x$ applies equally to the gradients $G_y$ and $G_z$.

As indicated above, the rf pulses are rendered selective by tailoring their pulse shape to suit the required spectral distribution function. An alternative method is to modulate the width of a series of rf pulses. This method is, however, rather wasteful of rf power, since a great deal appears in undesirable sidebands and harmonics. If the cosine transfrom c(t) of desired spectral distribution frequency function g ($\omega$) is used to amplitude-modulate the rf carrier then the resulting spectral distribution will be a doublet g ($+\omega$) about the carrier frequency $\omega_o$. One of this pair may be suppressed by also modulating with the sine transform s(t) a second carrier wave in quadrature phase with the first, then combining the two channels.

The magnet used to generate the magnetic field may be of any conventional form, for example a superconducting or non-superconducting magnet. It is preferred that the magnet is of a sufficient size to accommodate at least a portion of the body of a patient, so that the method and apparatus of the invention can be used to obtain an N.M.R. spectrum from a sample which is a living body. To this end the apparatus may be provided with a patient support, for example a chair or bed on which the patient may rest. The magnetic field is preferably homogeneous over a length of at least 10 cm, to enable a spectrum to be obtained from, for example, various elements within a cube of side 10 cms.

**Claims**

1. A method of obtaining an N.M.R. spectrum from a specific volume (6) within a sample volume (1), which method comprises:
—maintaining along an axis Z of the sample (1) a static homogeneous magnetic field $B_o$;
—applying to the sample (1) a first magnetic

field gradient $G_x$ in a first direction X and in its presence a first rf pulse (10) to effect selective saturation of all spins of a particular type within the sample (1) except for those lying in a slice (2) of a limited width $\Delta x$ normal to said first direction X;

—applying to the sample (1) a second magnetic field gradient $G_y$ in a second direction Y normal to said first direction X and in its presence a second rf pulse (11) to effect selective saturation of all spins of a particular type within the sample (1) except for those lying in a slice (3) of a limited width $\Delta_y$ normal to said second direction Y; characterized by

—applying to the sample (1) a third magnetic field gradient $G_z$ in a third direction Z normal to said first and second direitions X, Y and in its presence a third rf pulse (12) to effect selective interaction with all spins of a particular type within the sample (1) lying in a slice (5) of a limited width $\Delta_z$ normal to said third direction Z; and

—monitoring the free induction decay of all of the spins of the particular type, contained in the specific volume (6) defined by the magnetic field gradients $G_x$, $G_y$, $G_z$ and the rf pulses (10, 11, 12) respectively, after the third magnetic field gradient $G_z$ and the third rf pulse (12) have been removed, and thus in the presence of the static magnetic field $B_o$ only.

2. A method as claimed in claim 1, wherein the gradient $G_x$ in the said first direction X is maintained for a period of time sufficient to permit dephasing of nuclear spins of the portion of the sample volume (1) not contained within the said slice (2) before application of the next said gradient $G_y$.

3. A method as claimed in claims 1 or 2, wherein the third rf pulse (12) applied in the presence of the field gradient $G_z$ in the third direction is such as to enable refocusing of the signal evolution to produce a spin echo.

4. A method as claimed in claim 3, wherein a further rf pulse (28) is applied to the sample (1) after the third rf pulse (26) applied in the presence of the field gradient $G_z$ in the third direction Z, the said further rf pulse (28) being such as to cause 180° nutation of nuclear spins in the specific volume (6), whereby to cause refocusing of the signal evolution.

5. A method as claimed in claim 4, wherein a field gradient $G'_z$ (29) in the said third direction Z is applied to the sample (1) after application of the said further rf pulse (28), said further rf pulse (28) causing an echo signal having a portion forming the free induction decay which is monitored after the field gradient $G'_z$ has been removed.

6. A method as claimed in claim 3, wherein refocusing of the signal evolution is carried out by reversing the direction of the magnetic field gradient $G_z$ applied along the said third direction Z after a predetermined period of time.

7. A method as claimed in one of claims 1 to 6, wherein at least one of the rf pulses for effecting the said selective saturation is a restoring pulse

(21, 24), adapted to reverse in the region of the said respective slice (2, 3), the saturating effect of a radio-frequency pulse (20, 23) adapted to saturate substantially all of the spins of the said type in the sample volume (1).

8. A method as claimed in claim 7, wherein the saturating pulse is applied in the substantial absence of field gradients.

9. A method as claimed in claim 8, wherein the saturating pulse has a duration of from 1 to 500 microseconds.

10. A method as claimed in one of claims 8 or 9, wherein the saturating pulse has a duration of about 50 microseconds.

11. A method as claimed in one of claims 1 to 10, wherein the magnetic field gradients have a magnitude of about $5 \cdot 10^{-5}$ T/cm (0.5 gauss/cm.).

12. A method as claimed in one of claims 1 to 11, wherein the said third direction Z is with the said axis of the sample (1) along which the magnetic field $B_o$ is applied.

13. Apparatus for obtaining an N.M.R. spectrum from a specific volume (6) within a sample volume (1), comprising means for applying to the sample a static homogeneous magnetic field, means for successively applying to the sample (1) magnetic field gradients $G_x$, $G_y$, $G_z$ in each of three mutually orthogonal directions X, Y, Z, at least one rf transmitter for successively applying rf pulses (10, 11, 12) to the sample (1) in the presence of said magnetic field gradients $G_x$, $G_y$, $G_z$, and to selectively saturate the spins of a particular type within the sample (1) except for those lying in two slices (2, 3) of limited width ($\Delta x$, $\Delta y$) normal to the direction of two of the magnetic field gradients, respectively, characterized in that means are provided for selectively interacting with the spins of a particular type within the sample lying in a slice (5) of limited width ($\Delta z$) normal to the directions of the two gradients and for obtaining an output signal which is indicative of the free induction decay of the said selectively effected spins from the specific volume (6) after the said magnetic field gradients $G_x$, $G_y$, $G_z$ and the rf pulses (10, 11, 12) have been removed, and thus in the presence of the static homogeneous magnetic field $B_o$ only.

14. Apparatus as claimed in claim 13, including a first rf generator adapted to generate a relatively high amplitude rf signal (20, 23) and a second rf generator adapted to generate a relatively low amplitude rf signal (21, 24).

15. Apparatus as claimed in claim 13, including an rf transmitter adapted to be switched between a first mode in which its output is relatively high and a second mode in which its output is relatively low.

16. Apparatus as claimed in one of claims 13 to 15, including sequencing means for controlling the field gradient applying means and the at least one rf transmitter, in the following sequence:

(i) to apply a relatively high magnitude rf pulse (20) in the absence of any field gradient to saturate all spins of a particular type in the said sample volume (1),

(ii) to apply a field gradient $G_x$ in a first direction X and a relatively low magnitude rf pulse (21) in the presence of the said field gradient $G_x$ to selectively desaturate spins of the said type lying in a slice (2) normal to the said first direction X.

(iii) to apply a second relatively high magnitude rf pulse (23) in the absence of any magnetic field gradient to again saturate substantially all spins of a particular type in the said sample volume (1),

(iv) to apply a field gradient in a second direction Y and a relatively low magnitude rf pulse (24) in the presence of the said field gradient $G_y$ to selectively desaturate spins of the said type lying in a slice (3) normal to the said second direction Y,

(v) to apply a field gradient $G_z$ in the third direction Z and a relatively low magnitude rf pulse (26) in the presence of the said field gradient $G_z$ to selectively interact with spins of the said type in a small element (6) of the said sample volume (1).

17. Apparatus as claimed in claim 16, wherein the said at least one rf transmitter is sequenced to produce a further rf pulse (28) after step (v) to cause refocusing of the signal obtained.

18. Apparatus as claimed in one of claims 13 to 17, wherein the means for applying a magnetic field $B_o$ is of a size such as to accommodate within the magnetic field $B_o$ at least a portion of the body of a human patient.

19. Apparatus as claimed in claim 18, incorporating a patient support, for supporting a patient with a portion of the body of the patient in the homogeneous magnetic field $B_o$. .

**Patentansprüche**

1. Verfahren zum Gewinnen eines NMR-Spektrums aus einem spezifischen Volumen (6) innerhalb eines Probenvolumens (1), welches Verfahren aufweist:

—das Aufrechterhalten eines statischen homogenen Magnetfeldes $B_o$ längs einer Achse Z der Probe (1);

—das Anlegen eines ersten magnetischen Feldgradienten $G_x$ in einer ersten Richtung X an die Probe und in seiner Anwesenheit das Einstrahlen eines ersten Hochfrequenzimpulses (10) auf die Probe (1), um eine selektive Sättigung aller Spins eines speziellen Typs innerhalb der Probe (1) mit Ausnahme jener zu bewirken, die in einer zu der ersten Richtung X rechtwinklig verlaufenden Scheibe oder Schicht (2) einer begrenzten Breite Δx liegen;

—das Anlegen eines zweiten magnetischen Feldgradienten $G_y$ in einer zweiten Richtung Y, die zur ersten Richtung X rechtwinklig ist, an die Probe (1) und in seiner Anwesenheit das Einstrahlen eines zweiten Hochfrequenzimpulses (11) auf die Probe (1), um eine selektive Sättigung aller Spins eines speziellen Typs innerhalb der Probe (1) mit Ausnahme jener zu bewirken, die in einer zu der zweiten Richtung Y rechtwinklig verlaufenden Scheibe (3) einer begrenzten Breite Δy liegen, gekennzeichnet durch

—das Anlegen eines dritten magnetischen Feldgradienten $G_z$ in einer dritten Richtung Z, die rechtwinklig zu der ersten und zweiten Richtung X und Y verläuft, an die Probe (1) und in seiner Anwesenheit das Einstrahlen eines dritten Hochfrequenzimpulses (12) auf die Probe (1), um eine selektive Wechselwirkung allen Spins eines speziellen Typs innerhalb der Probe (1) zu bewirken, die in einer zu der dritten Richtung Z rechtwinklig verlaufenden Scheibe (5) einer begrenzten Breite Δz liegen; und

—das Detektieren des freien Induktionsabfalls aller Spins des speziellen Typs, die in dem spezifischen Volumen (6) enthalten sind, das durch die magnetischen Feldgradienten $G_x$, $G_y$, $G_z$ bzw. die Hochfrequenzimpulse (10, 11, 12) definiert wird, nachdem der dritte magnetische Feldgradient $G_z$ und der dritte Hochfrequenzimpulse (12) entfernt worden sind und somit lediglich bei Anwesenheit des statischen Magnetfelds $B_o$.

2. Verfahren nach Anspruch 1, dadurch gekennzeichnet, daß der Gradient $G_x$ in der ersten Richtung X während einer Zeitspanne aufrechterhalten wird, die ausreicht, um es zu erlauben, daß vor dem Anlegen des nächsten Gradienten $G_y$ Kernspins des Teils des Probenvolumens (1), das nicht innerhalb der genannten Scheibe (2) enthalten ist, außer Phase kommen.

3. Verfahren nach Anspruch 1 oder 2, dadurch gekennzeichnet, daß der dritte Hochfrequenzimpuls (12), der bei Anwesenheit des Feldgradienten $G_z$ in der dritten Richtung eingestrahlt wird, derart gewählt ist, daß er ein Refokussieren oder Bündeln der Signalevolution ermöglicht, um ein Spinecho zu erzeugen.

4. Verfahren nach Anspruch 3, dadurch gekennzeichnet, daß ein weiterer Hochfrequenzimpuls (28) auf die Probe (1) nach dem dritten Hochfrequenzimpuls (26), der bei Anwesenheit des Feldgradienten $G_z$ in der dritten Richtung Z auf die Probe eingestrahlt wird, eingestrahlt wird, und daß der weitere Hochfrequenzimpuls (28) derart gewählt ist, daß er eine 180°-Nutation der Kernspins in dem spezifischen Volumen (6) bewirkt, um dadurch ein Refokussieren der Signalevolution zu bewirken.

5. Verfahren nach Anspruch 4, dadurch gekennzeichnet, daß ein Feldgradient $G'_z$ (29) in der dritten Richtung Z an die Probe (1) nach dem Einstrahlen des weiteren Hochfrequenzimpulses (28) angelegt wird, daß der weitere Hochfrequenzimpuls (28) ein Echosignal bewirkt, das einen Teil hat, der den freien Induktionsabfall bildet, der überwacht wird, nachdem der Feldgradient $G'_z$ entfernt worden ist.

6. Verfahren nach Anspruch 3, dadurch gekennzeichnet, daß das Refokussieren der Signalevolution durch Umkehren der Richtung des magnetischen Feldgradienten $G_z$, der längs der dritten Richtung Z angelegt wird, nach einer vorbestimmten Zeitspanne ausgeführt wird.

7. Verfahren nach einem der Ansprüche 1 bis 6, dadurch gekennzeichnet, daß mindestens einer der Hochfrequenzimpulse zum Bewirken der selektiven Sättigung ein Rückstellimpuls (Restoring-Impuls) (21, 24) ist, der geeignet ist, im Gebiet der entsprechenden Scheibe (2, 3) den Sättigungseffekt eines Hochfrequenzimpulses (20, 23), der geeignet ist, um wesentlichen alle Spins des genannten Typs in dem Probenvolumen (1) zu sättigen, aufzuheben.

8. Verfahren nach Anspruch 7, dadurch gekennzeichnet, daß der Sättigungsimpuls im wesentlichen bei Abwesenheit von Feldgradienten eingestrahlt wird.

9. Verfahren nach Anspruch 8, dadurch gekennzeichnet, daß der Sättigungsimpuls einer Dauer von 1 bis 500 Mikrosekunden hat.

10. Verfahren nach Anspruch 8 oder 9, dadurch gekennzeichnet, daß der Sättigungsimpuls eine Dauer von etwa 50 Mikrosekunden hat.

11. Verfahren nach einem der Ansprüche 1 bis 10, dadurch gekennzeichnet, daß die magnetischen Feldgradienten eine Stärke von ungefähr $5 \times 10^{-3}$ T/cm (0,5 Gauss/cm) haben.

12. Verfahren nach einem der Ansprüche 1 bis 11, dadurch gekennzeichnet, daß die dritte Richtung Z in der Richtung der genannten Achse der Probe (1) verläuft, in der das Magnetfeld $B_o$ angelegt wird.

13. Vorrichtung zum Gewinnen eines NMR-Spektrums aus einem spezifischen Volumen (6) innerhalb eines Probenvolumens (1), die eine Vorrichtung zum Anlegen eines statischen homogenen Magnetfeldes an die Probe, eine Vorrichtung zum aufeinanderfolgenden Anlegen von magnetischen Feldgradienten $G_x$, $G_y$, $G_z$ and die Probe in jeder der drei gegenseitig orthogonalen Richtungen X, Y und Z, und mindestens einen Hochfrequenzsender zum aufeinanderfolgenden Einstrahlen von Hochfrequenzimpulsen (10, 11, 12) auf die Probe (1) bei Anwesenheit der magnetischen Feldgradienten $G_x$, $G_y$, $G_z$ und zum selektiven Sättigen der Spins des speziellen Typs innerhalb der Probe (1) mit Ausnahme jener, die in zwei jeweils rechtwinklig zu der Richtung von zwei der magnetischen Feldgradienten verlaufenden Scheiben (2, 3) von begrenzter Breite ($\Delta x$, $\Delta y$) liegen, aufweist, dadurch gekennzeichnet, daß eine Vorrichtung zur selektiven Wechselwirkung mit den Spins der spetiellen Typs innerhlab der Probe (1), die innerhalb einer Scheibe (5) von begrenzter Breite ($\Delta z$) liegen, die rechtwinklig in den Richtungen der zwei Gradienten verläuft, und zum Gewinnen eines Ausgangssignals vorgesehen ist, das den freien Induktionsabfall der selektiv bewirkten Spins aus dem spezifischen Volumen (6) anzeigt, nachdem die magnetischen Feldgradienten ($G_x$, $G_y$, $G_z$) und die Hochfrequenzimpulse (10, 11, 12) entfernt worden sind und somit lediglich bei Anwesenheit des statischen homogen Magnetfeldes $B_o$.

14. Vorrichtung nach Anspruch 13, dadurch gekennzeichnet, daß sie einen ersten Hochfrequenzgenerator, der so ausgebildet ist, daß er ein Hochfrequenzsignal (20, 23) mit relativ großer Amplitude erzeugt, und einen zweiten Hochfrequenzgenerator aufweist, der so ausgebildet ist, daß er ein Hochfrequenzsignal (21, 24) mit relativ kleiner Amplitude erzeugt.

15. Vorrichtung nach Anspruch 13, dadurch gekennzeichnet, daß sie einen Hochfrequenzsender aufweist, der so ausgebildet ist, daß er zwischen einem ersten Betriebszustand, bei dem sein Ausgangssignal relativ groß ist, und einem zweiten Betriebszustand, bei dem sein Ausgangssignal relativ klein ist, umgeschaltet werden kann.

16. Vorrichtung nach einem der Ansprüche 13 bis 15, dadurch gekennzeichnet, daß sie eine Folgeschaltungsvorrichtung zum Steuern der die Feldgradienten anlegenden Vorrichtung und des mindestens einen Hochfrequenzsenders in der folgenden Reihenfolge aufweist:

(I) Einstrahlen eines relativ starken Hochfrequenzimpulses (20) bei Abwesenheit aller Feldgradienten, um alle Spins eines speziellen Typs in dem Probenvolumen (1) zu sättigen,

(II) Anlegen eines Feldgradienten $G_x$ in einer ersten Richtung X und Einstrahlen eines relativ schwachen Hochfrequenzimpulses (21) bei Anwesenheit des ersten Feldgradienten $G_x$, um selektiv Spins des genannten Typs, die in einer rechtwinklig zu der ersten Richtung X verlaufenden Scheibe (2) liegen, zu entsättigen,

(III) Einstrahlen eines zweiten relativ starken Hochfrequenzimpulses (23) bei Abwesenheit aller Magnetfeldgradienten, um wiederum im wesentlichen alle Spins eines speziellen Typs in dem Probemvolumen (1) zu sättigen,

(IV) Anlegen eines Feldgradienten in einer zweiten Richtung Y und Einstrahlen eines relativ schwachen Hochfrequenzimpulses (24) bei Anwesenheit des Feldgradienten $G_y$, um selektiv Spins des genannten Typs, die in einer rechtwinklig zu der zweiten Richtung Y verlaufenden Scheibe (3) liegen, zu entsättigen,

(V) Anlegen eines Feldgradienten $G_z$ in der dritten Richtung Z und Einstrahlen eines relativ schwachen Hochfrequenzimpulses (26) bei Anwesenheit des Feldgradienten $G_z$, um selektiv mit Spins des genannten Typs in einem kleinen Element (6) des Probenvolumens (1) in Wechselwirkung zu treten.

17. Vorrichtung nach Anspruch 16, dadurch gekennzeichnet, daß der mindestens eine Hochfrequenzsender so geschaltet wird, daß er einen weiteren Hochfrequenzimpuls (28) nach dem Schritt (V) erzeugt, um ein Refokussieren oder Bündeln des gewonnenen Signals zu bewirken.

18. Vorrichtung nach einem der Ansprüche 13 bis 17, dadurch gekennzeichnet, daß die Vorrichtung zum Anlegen eines Magnetfelds $B_o$ eine Größe hat, die so gewählt ist, daß sie innerhalb des Magnetfelds $B_o$ mindestens einen Teil des Körpers eines menschlichen Patienten aufnehmen kann.

19. Vorrichtung nach Anspruch 18, dadurch gekennzeichnet, daß sie eine Patientenlagerung zum Lagern eines Patienten mit einem Teil seines Körpers in dem homogenen Magnetfeld $B_o$ aufweist.

## Revendications

1. Procédé pour l'obtention d'un spectre de RMN à partir d'un volume particulier (6) dans un volume d'échantillon (1), comprenant les opérations consistant

—à maintenir, le long d'un axe Z de l'échantillon (1), un champ magnétique homogène statique $B_o$;

—à appliquer à l'échantillon (1) un premier gradient de champ magnétique $G_x$ dans une première direction X et, en présence de celui-ci, une première impulsion H.F. (10) pour produire une saturation sélective de tous les spins d'un type particulier dans l'échantillon (1), à l'exception de ceux qui se trouvent dans une tranche (2) de largeur limitée $\Delta_x$ perpendiculaire à ladite première direction X;

—à appliquer à l'échantillon (1) un deuxième gradient de champ magnétique $G_y$ dans une deuxième direction Y perpendiculaire à ladite première direction X et, en présence de celui-ci, une deuxième impulsion H.F. (11) pour produire une saturation sélective de tous les spins d'un type particulier dans l'échantillon (1), à l'exception de ceux qui se trouvent dans une tranche (3) de largeur limitée $\Delta_y$ perpendiculaire à ladite deuxième direction Y;

caractérisé par les opérations consistant

—à appliquer à l'échantillon (1) un troisième gradient de champ magnétique $G_z$ dans une troisième direction Z perpendiculaire auxdites première et deuxième directions X, Y et, en présence de celui-ci, une troisième impulsion H.F. (12) pour produire une interaction sélective avec tous les spins d'un type particulier dans l'échantillon (1), qui se trouvent dans une tranche (5) de largeur limitée $\Delta_z$ perpendiculaire à ladite troisième direction Z;

—à examiner l'affaiblissement de l'induction libre de tous les spins du type particulier, contenus dans le volume particulier (6) défini par les gradients de champ magnétiques $G_x$, $G_y$, $G_z$ et les impulsions H.F. (10, 11, 12) respectivement, après que le troisième gradient de champ magnétique $G_z$ et la trousième impulsion H.F. (12) ont été supprimés et, par conséquent, en présence du seul champ magnétique $B_o$.

2. Procédé selon la revendication 1, dans lequel le gradient $G_x$ dans ladite première direction X est maintenu pendant une période de temps suffisante pour permettre le déphasage de spins nucléaires de la partie du volume d'échantillon (1) non contenue dans ladite tranche (2) avant l'application dudit gradient suivant $G_y$.

3. Procédé selon la revendication 1 ou 2, dans lequel la troisième impulsion H.F. (12) appliquée en présence du gradient de champ $G_z$ dans la troisième direction est telle qu'elle permette la refocalisation de l'évolution du signal pour produire un écho des spins.

4. Procédé selon la revendication 3, dans lequel une impulsion H.F. supplémentaire (28) est appliquée à l'échantillon (1) après la troisième impulsion H.F. (26) appliquée en présence du gradient de champ $G_z$ dans la troisième direction Z, cette impulsion H.F. supplémentaire (28) étant telle qu'elle provoque une nutation de 180° des spins nucléaires dans le volume particulier (6), de façon à produire la refocalisation de l'évolution du signal.

5. Procédé selon la revendication 4, dans lequel un gradient de champ $G'_z$ (29) dans ladite troisième direction Z est appliquée à l'échantillon (1) après l'application de ladite impulsion H.F. supplémentaire (28), cette impulsion H.F. supplémentaire (28) donnant un signal d'écho dont une partie forme l'affaiblissement de l'induction libre qui est examinée après que le gradient de champ $G'_z$ a été supprimé.

6. Procédé selon la revendication 3, dans lequel le refocalisation de l'évolution du signal est effectuée par inversion de la direction du gradient de champ magnétique $G_z$ appliqué le long de ladite troisième direction Z, après une période de temps prédéterminée.

7. Procédé selon l'une quelconque des revendications 1 à 6, dans lequel l'une au moins des impulsions H.F. destinée à produire ladite saturation sélective est une impulsion de rétablissement (21, 24) propre à inverser, dans la région de ladite tranche respective (2, 3), l'effet de saturation d'une impulsion à haute fréquence (20, 23) propre à saturer pratiquement la totalité des spins dudit type dans le volume de l'échantillon (1).

8. Procédé selon la revendication 7, dans lequel l'impulsion de saturation est appliquée pratiquement en l'absence de gradients de champ.

9. Procédé selon la revendication 8, dans lequel l'impulsion de saturation a une durée comprise entre 1 et 500 microsecondes.

10. Procédé selon la revendication 8 ou 9, dans lequel l'impulsion de saturation a une durée d'environ 50 microsecondes.

11. Procédé selon l'une quelconque des revendications 1 à 10, dans lequel les gradients de champ magnétique ont une grandeur d'environ $5 \cdot 10^{-5}$ T/cm (0,5 gauss/cm).

12. Procédé selon l'une quelconque des revendications 1 à 11, dans lequel ladite troisième direction Z correspond audit axe de l'échantillon (1) le long duquel le champ magnétique $B_o$ est appliqué.

13. Appareil pour l'obtention d'un spectre de RMN à partir d'un volume particulier (6) dans un volume d'échantillon (1), comprenant des moyens pour appliquer à l'échantillon un champ magnétique homogène statique, des moyens pour appliquer successivement à l'échantillon (1) des gradients de champ magnétique $G_x$, $G_y$, $G_z$ dans chacune de trois directions X, Y, Z mutuellement orthogonales, au moins un émetteur H.F. pour appliquer successivement des impulsions H.F. (10, 11, 12) à l'échantillon (1) en présence desdits gradients de champ magnétique $G_x$, $G_y$, $G_z$ et saturer sélectivement les spins d'un type particulier dans l'échantillon (1) à l'exception de ceux qui se trouvent dans deux tranches (2, 3) de largeur limitée ($\Delta_x$, $\Delta y$) perpendiculaires à la direciton de deux gradients de champ magnétique respectivement, caractérisé en ce que des moyens sont prévus pour interagir selectivement avec les spin d'un type particulier dans l'échantillon (1) qui se trouvent dans une tranche (5) de

largeur limitée (Δz) perpendiculaire à la direction des deux gradients et. l'obtention d'un signal de sortie qui indique l'affaiblissement de l'induction libre desdits spins saturés sélectivement dans le volume particulier (6), après que lesdits gradients de champ magnétique $G_x$, $G_y$, $G_z$ et les impulsions H.F. (10, 11, 12) ont été supprimés et, par conséquent, en présence du seul champ magnétique homogène statique $B_o$.

14. Appareil selon la revendication 13, contenant un premier générateur H.F. destiné à générer un signal H.F. d'amplitude relativement élevée (20, 23) et un second générateur H.F. destiné à générer un signal H.F. d'amplitude relativement faible (21, 24).

15. Appareil selon la revendication 13, contenant un émetteur H.F. agencé de façon à être commuté entre un premier mode dans lequel sa sortie est relativement élevée et un second mode dans lequel sa sortie est relativement faible.

16. Appareil selon l'une quelconque des revendications 13 à 15, contenant des moyens séquenceurs pour commander les moyens d'application de gradient de champ et l'émetteur H.F. dans la séquence suivante:

(i) appliquer une impulsion H.F. d'amplitude relativement élevée (20) en l'absence de tout gradient de champ pour saturer tous les spins d'un type particulier dans ledit volume de l'échantillon (1),

(ii) appliquer un gradient de champ $G_x$ dans une première direction X et une impulsion H.F. d'amplitude relativement faible (21) en présence dudit gradient de champ $G_x$ pour désaturer sélectivement les spins dudit type se trouvant dans une tranche (2) perpendiculaire à ladite première direction X,

(iii) appliquer une deuxième impulsion H.F. d'amplitude relativement élevée (23) en l'absence de tout gradient de champ magnétique pour saturer de nouveau pratiquement tous les spins d'un type particulier dans ledit volume de l'échantillon (1),

(iv) appliquer un gradient de champ $G_y$ dans une deuxième direction Y et une impulsion H.F. d'amplitude relativement faible (24) en présence dudit gradient de champ $G_y$ pour désaturer les spins dudit type se trouvant dans une tranche (3) perpendiculaire à ladite deuxième direction Y,

(v) appliquer un gradient de champ $G_z$ dans la troisième direction Z et une impulsion H.F. d'amplitude relativement faible en présence dudit gradient de champ $G_z$ pour interagir sélectivement avec les spins dudit type dans un petit élément (6) dudit volume de l'échantillon (1).

17. Appareil selon la revendication 16, dans lequel ledit émetteur H.F. est programmé de façon à produire une impulsion H.F. supplémentaire (28) après l'étape (v), pour provoquer la refocalisation su signal obtenu.

18. Appareil selon l'une quelconque des revendications 13 à 17, dans lequel les moyens pour appliquer un champ magnétique $B_o$ ont des dimensions telles qu'au moins une partie du corps d'un patient humain puisse être contenue dans le champ magnétique $B_o$.

19. Appareil selon la revendication 18, contenant un support de patient pour supporter un patient de telle manière qu'une partie du corps de celui-ci se trouve dans le champ magnétique homogène $B_o$.

FIG. 1.

FIG. 2.

# FIG. 3.

RF Pulses

20  21  23  24  26  28

Field Gradients

22  25  27  29

$G_x$  $G_y$  $G_z$  $G'_z$

SPIN ECHO Signal

t  t

cycle time

EP 0 153 303 B1

FIG. 4A.

$A$

$\omega_1$    $\omega_x$    $\omega_2$    $\omega$

FIG. 4B.

$A$

$\omega$

FIG. 4C.

$A$

$\omega$